# EUROPEAN PATENT APPLICATION

(11) **EP 3 065 171 A2**
(43) Date of publication of application: **07.09.2016**
(21) Application number: 15159632.7
(22) Date of filing: 18.03.2015
(51) Int. Cl.: H01L 23/485, H01L 23/498, H01L 23/367

(54) **ELECTRONIC DEVICE AND ELECTRONIC PACKAGE THEREOF**

(30) Priority: 04.03.2015 US 201514638440
(71) Applicant: Delta Electronics, Inc., Taoyuan County 33341 (TW)
(72) Inventor: Lin, Shiau Shi, 33341 Taoyuan City (TW); Lee, Chia-Yen, 33341 Taoyuan Hsien (TW); Tsai, Hsin-Chang, 33341 Taoyuan Hsien (TW)
(74) Representative: Fuchs Patentanwälte Partnerschaft mbB

(57) **Abstract**

An electronic package is provided, including a substrate and a semiconductor chip. The substrate has a plurality of substrate pads. The semiconductor chip is mounted on the substrate, wherein the semiconductor chip includes a plurality of chip pads electrically connected to the substrate pads of the substrate respectively, and the substrate pads and the chip pads are both trapezoidal.

## Description

### CROSS REFERENCE TO RELATED APPLICATIONS

This Application claims priority of US Patent Application No. 14/638,440, filed on Mar. 4, 2015, the entirety of which is incorporated by reference herein.

### BACKGROUND OF THE INVENTION

### Field of the Invention

The present invention relates to an electronic package, and in particular to an electronic package with a semiconductor chip.

### Description of the Related Art

In a conventional electronic package, a semiconductor chip has a plurality of small dimensional chip pads. Conventionally, the semiconductor chip must be connected to the top of an IC carrier, and the IC carrier is connected to the printed circuit board on the bottom thereof The heat of the semiconductor chip travels from the semiconductor chip, and passes through the IC carrier to the printed circuit board. The heat dissipation path of the conventional electronic package is circuitous, and the heat dissipation efficiency of the conventional electronic package is poor.

### BRIEF SUMMARY OF THE INVENTION

In one embodiment of the invention, an electronic package is provided, comprising a substrate and a semiconductor chip. The substrate has a plurality of substrate pads. The semiconductor chip is mounted on the substrate, wherein the semiconductor chip comprises a plurality of chip pads electrically connected to the substrate pads of the substrate respectively, and the substrate pads and the chip pads are both trapezoidal.

In one embodiment, the semiconductor chip comprises a plurality of active elements electrically connected to the chip pads.

In one embodiment, the active elements comprise a plurality of power transistors, a plurality circuit trace and channel.

In one embodiment, the substrate comprises a plurality of thermal via holes connected to the substrate pads.

In one embodiment, more than one of the thermal via holes is connected to each of the substrate pads. (more than one= at least one? TOPTEAM: One is included)

In one embodiment, each of the substrate pads comprises a wider side and a narrower side opposite the wider side.

In one embodiment, at least one of the substrate pads has a wider side adjacent to the narrower side of another substrate pad.

In one embodiment, the thermal via holes are adjoined with the substrate pad in a location that is adjacent to the wider side.

In one embodiment, heat from the semiconductor chip is conducted to the substrate via the chip pad, the substrate pad and the thermal via hole along a dissipation path, and the main dissipation path is a straight line.

In one embodiment, the substrate comprises a plurality of traces, and the traces are perpendicular to the thermal via holes.

In one embodiment, the substrate pads are formed on the substrate via electric coating.

In one embodiment, the diameter of the thermal via hole is larger than 50um.

In one embodiment, the semiconductor chip comprises a bottom surface, and the chip pads protrude from the bottom surface.

In one embodiment, the bottom surface comprises insulation material.

In one embodiment, the bottom surface comprises SiO₂ or SiNₓ.

In one embodiment, the shape of the substrate pad is the same as the shape of the corresponding chip pad.

In one embodiment, the dimensions of the substrate pad are similar to the dimensions of the corresponding chip pad.

In one embodiment, the substrate comprises a printed circuit board or an interposer.

In one embodiment, the thickness of the chip pads is greater than 5µm.

A detailed description is given in the following embodiments with reference to the accompanying drawings.

### BRIEF DESCRIPTION OF THE DRAWINGS

The present invention can be more fully understood by reading the subsequent detailed description and examples with references made to the accompanying drawings, wherein:
FIG. 1 shows an electronic package of a first embodiment of the invention;
FIG. 2 shows the detailed structure of a substrate of the first embodiment of the invention;
FIG. 3 shows the detailed structure of a semiconductor chip of the first embodiment of the invention;
FIG. 4 is a block diagram of the semiconductor chip of the first embodiment of the invention;
FIG. 5 shows an electronic package of a second embodiment of the invention;
FIG. 6 shows the detailed structure of a substrate of the second embodiment of the invention;
FIG. 7 shows the detailed structure of a semiconductor chip of the second embodiment of the invention;
FIG. 8 is a block diagram of the semiconductor chip of the second embodiment of the invention;
FIG. 9 shows a portion of a semiconductor chip having two sources and a drain;
FIG. 10 is a top plan view of the embodiment shown in FIG. 9 which shows additional sources, drains, and first-layer interconnect source runners and drain runners;
FIG. 11 is a top plan view of the embodiment of FIG. 9, which shows the first interconnect layer, second interconnect layer, and third interconnect layer forming the source pad;
FIG. 12 is a top plan view of the embodiment of FIG. 9, which shows the first interconnect layer, second interconnect layer, and third interconnect layer forming a drain pad; and
FIG. 13 shows a layout where each source pad and drain pad are shaped as "stripes" and are interleaved with each other.

### DETAILED DESCRIPTION OF THE INVENTION

The following description is of the best-contemplated mode of carrying out the invention. This description is made for the purpose of illustrating the general principles of the invention and should not be taken in a limiting sense. The scope of the invention is best determined by reference to the appended claims.

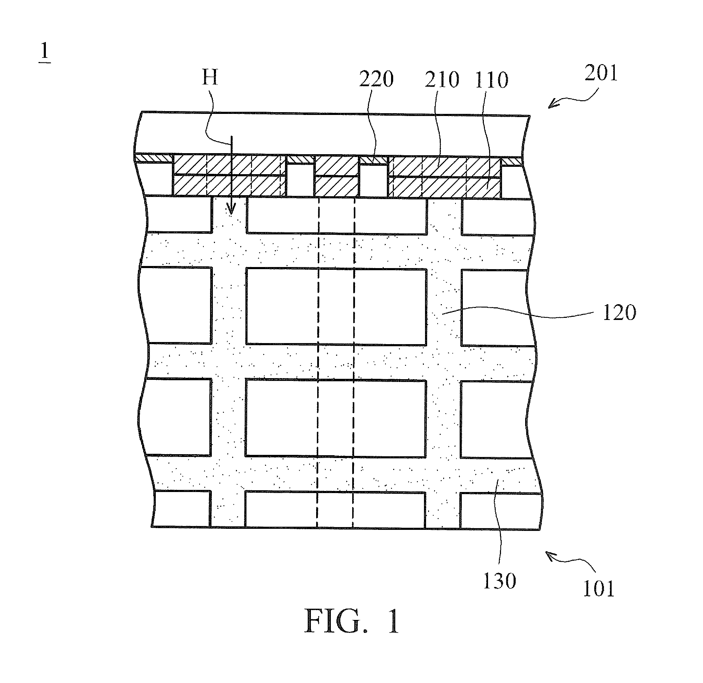

FIG. 1 shows an electronic package 1 of a first embodiment of the invention, the electronic package comprises a substrate 101 and a semiconductor chip 201. The substrate 101 has a plurality of substrate pads 110. The semiconductor chip 201 is mounted on the substrate 101. The semiconductor chip 201 comprises a plurality of chip pads 210 electrically connected to the respective substrate pads 110 of the substrate 101. In one embodiment, the substrate 101 comprises a printed circuit board or an interposer.

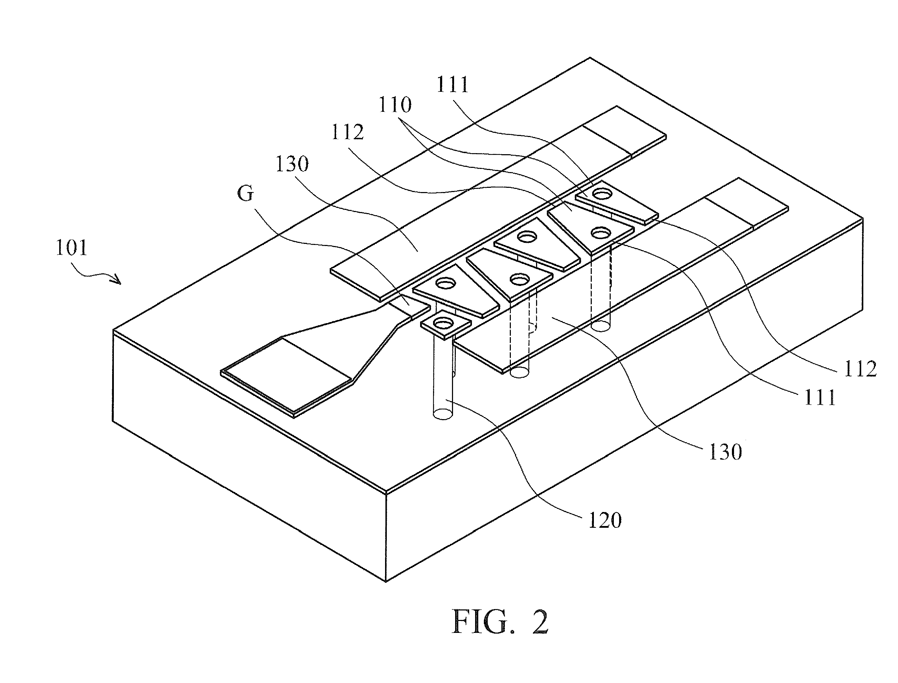

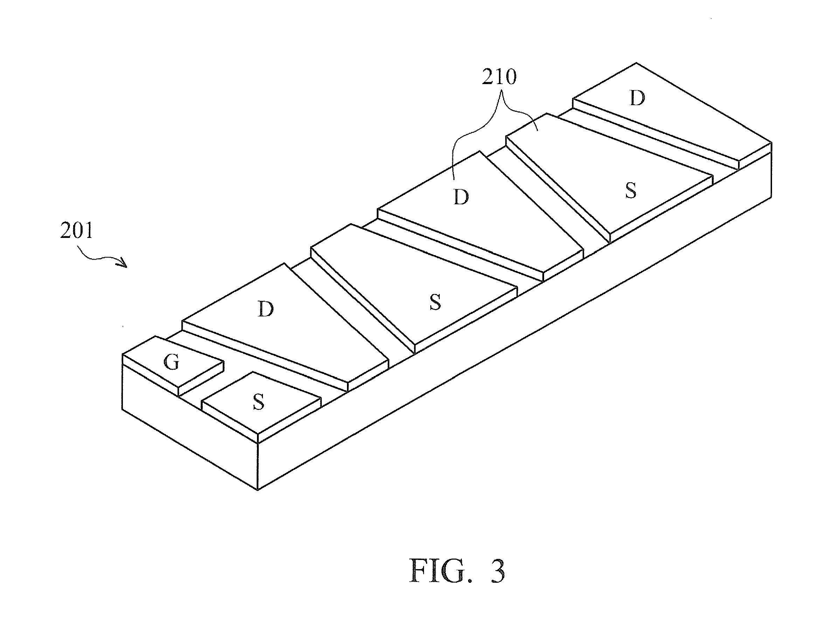

FIG. 2 shows the detailed structure of the substrate 101. FIG. 3 shows the detailed structure of the semiconductor chip 201. As shown in FIGs. 2 and 3, the substrate pads 110 and the chip pads 210 are both trapezoidal.

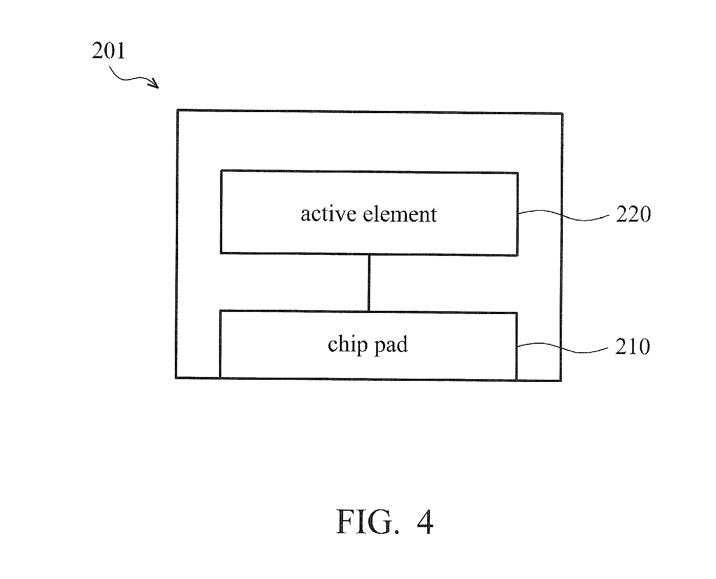

With reference to FIG. 4, in one embodiment, the semiconductor chip 201 comprises a plurality of active elements 220 electrically connected to the chip pads 210. In one embodiment, the active elements comprise a plurality of power transistors. With reference to FIG. 3, the chip pads 210 comprise a gate electrode G, source electrodes S and drain electrodes D. The source electrodes S and the drain electrodes D are staggered with each other. In one embodiment, the thickness of the chip pads 210 is greater than 5µm.

With reference to FIG. 2, the substrate 101 comprises a plurality of thermal via holes 120 connected to the substrate pads 110. In this embodiment, one thermal via hole 120 is connected to one substrate pad 110.

With reference to FIG. 2, each of the substrate pads 110 comprises a wider side 111 and a narrower side 112 opposite the wider side 111. At least one of the substrate pads 110 has a wider side 111 adjacent to the narrower side 112 of another substrate pad 110. In one embodiment, the width of the wider side 111 is greater than 150µm. The wider side 111 is parallel to the narrower side 112.

With reference to FIG. 2, the thermal via hole 120 is adjoined with the substrate pad 110 in a location that is adjacent to the wider side 111.

With reference to FIG. 1, utilizing the embodiment of the first embodiment, heat H generated by the semiconductor chip 201 is conducted to the substrate 101 via the chip pad 210, the substrate pad 110 and the thermal via hole 120 along a dissipation path, and the dissipation path is a straight line.

With reference to FIGs. 1 and 2, the substrate 101 comprises a plurality of traces 130, and the traces 130 are perpendicular to the thermal via holes 120.

With reference to FIGs. 1 and 2, in one embodiment, the substrate pads 110 are formed on the substrate 101 via electric coating.

With reference to FIG. 1, in one embodiment, the semiconductor chip comprises a bottom surface 220, and the chip pads 210 protrude from the bottom surface 220. The bottom surface 220 comprises insulation material, such as SiO₂ or SiNₓ.

With reference to FIGs. 2 and 3, the shape of the substrate pad 110 is the same as the shape of the corresponding chip pad 210. In one embodiment, the dimensions of the substrate pad 110 are similar to the dimensions of the corresponding chip pad.

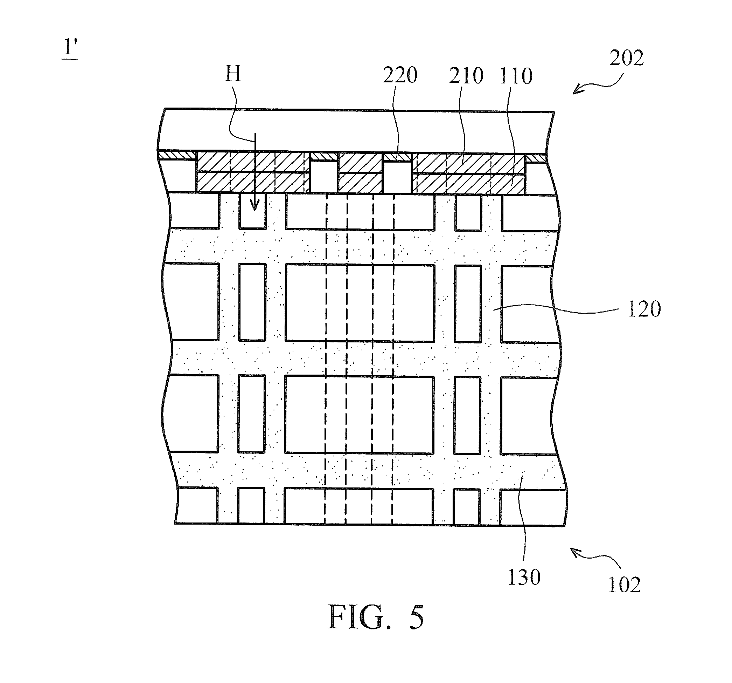

FIG. 5 shows an electronic package 1' of a second embodiment of the invention, the electronic package comprises a substrate 102 and a semiconductor chip 202. The substrate 102 has a plurality of substrate pads 110. The semiconductor chip 202 is mounted on the substrate 102. The semiconductor chip 202 comprises a plurality of chip pads 210 electrically connected to the respective substrate pads 110 of the substrate 102. In one embodiment, the substrate 102 comprises a printed circuit board or an interposer.

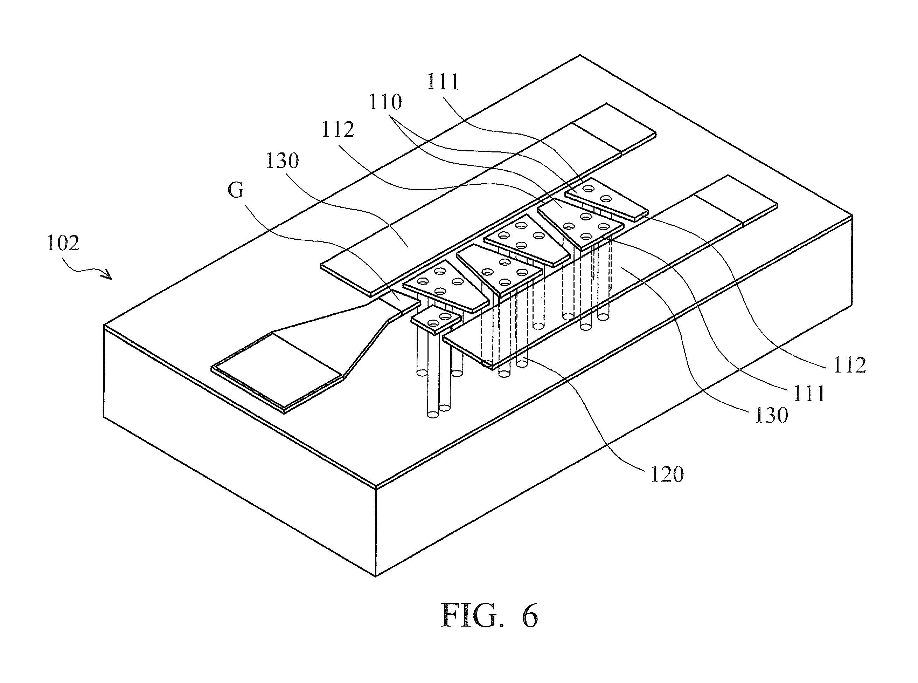

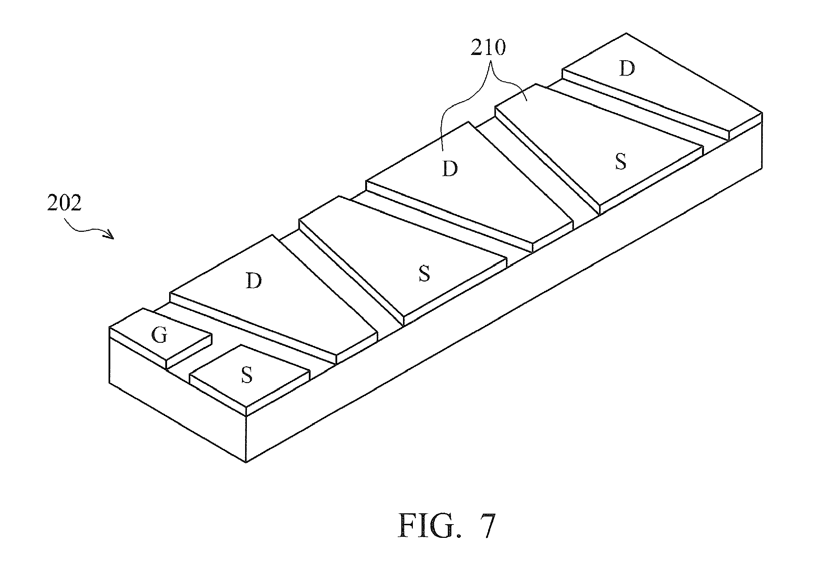

FIG. 6 shows the detailed structure of the substrate 102. FIG. 7 shows the detailed structure of the semiconductor chip 202. As shown in FIGs. 6 and 7, the substrate pads 110 and the chip pads 210 are both trapezoidal.

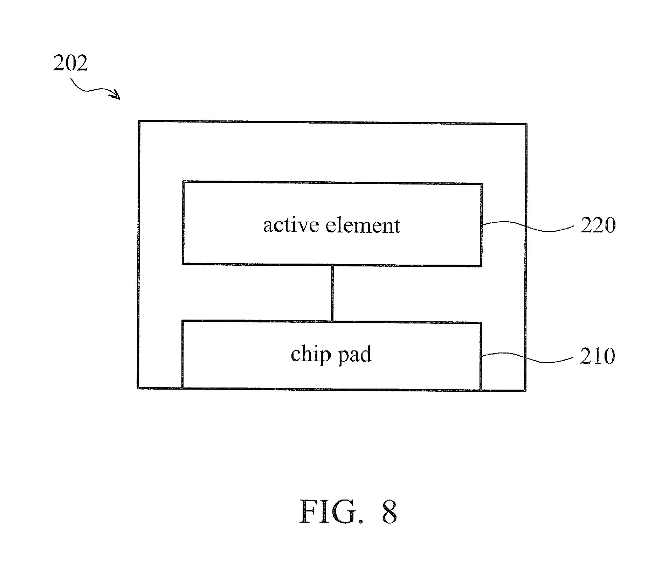

With reference to FIG. 8, in one embodiment, the semiconductor chip 202 comprises a plurality of active elements 220 electrically connected to the chip pads 210. In one embodiment, the active elements comprise a plurality of power transistors. With reference to FIG. 7, the chip pads 210 comprise a gate electrode G, source electrodes S and drain electrodes D. The source electrodes S and the drain electrodes D are staggered with each other. In one embodiment, the thickness of the chip pads 210 is greater than 5µm.

With reference to FIG. 6, the substrate 102 comprises a plurality of thermal via holes 120 connected to the substrate pads 110. In this embodiment, more than one of the thermal via holes 120 are connected to each of the substrate pads 110.

With reference to FIG. 6, each of the substrate pads 110 comprises a wider side 111 and a narrower side 112 opposite the wider side 111. At least one of the substrate pads 110 has a wider side 111 adjacent to the narrower side 112 of another substrate pad 110. In one embodiment, the width of the wider side 111 is greater than 150µm. The wider side 111 is parallel to the narrower side 112.

With reference to FIG. 6, the thermal via holes 120 are adjoined with the substrate pad 110 in a location that is adjacent to the wider side 111.

With reference to FIG. 5, utilizing the embodiment of the first embodiment, heat H generated by the semiconductor chip 202 is conducted to the substrate 102 via the chip pad 210, the substrate pad 110 and the thermal via hole 120 along a dissipation path, and the dissipation path is a straight line.

With reference to FIGs. 5 and 6, the substrate 102 comprises a plurality of traces 130, and the traces 130 are perpendicular to the thermal via holes 120.

With reference to FIGs. 5 and 6, in one embodiment, the substrate pads 110 are formed on the substrate 102 via electric coating.

With reference to FIG. 5, in one embodiment, the semiconductor chip comprises a bottom surface 220, and the chip pads 210 protrude from the bottom surface 220. The bottom surface 220 comprises insulation material, such as SiO₂ or SiNₓ.

With reference to FIGs. 6 and 7, the shape of the substrate pad 110 is the same as the shape of the corresponding chip pad 210. In one embodiment, the dimensions of the substrate pad 110 are similar to the dimensions of the corresponding chip pad.

In one embodiment of the invention, the dimensions of the substrate pad are similar to the dimensions of the corresponding chip pad. The structure of the semiconductor chip with large-dimensional chip pad is described below.

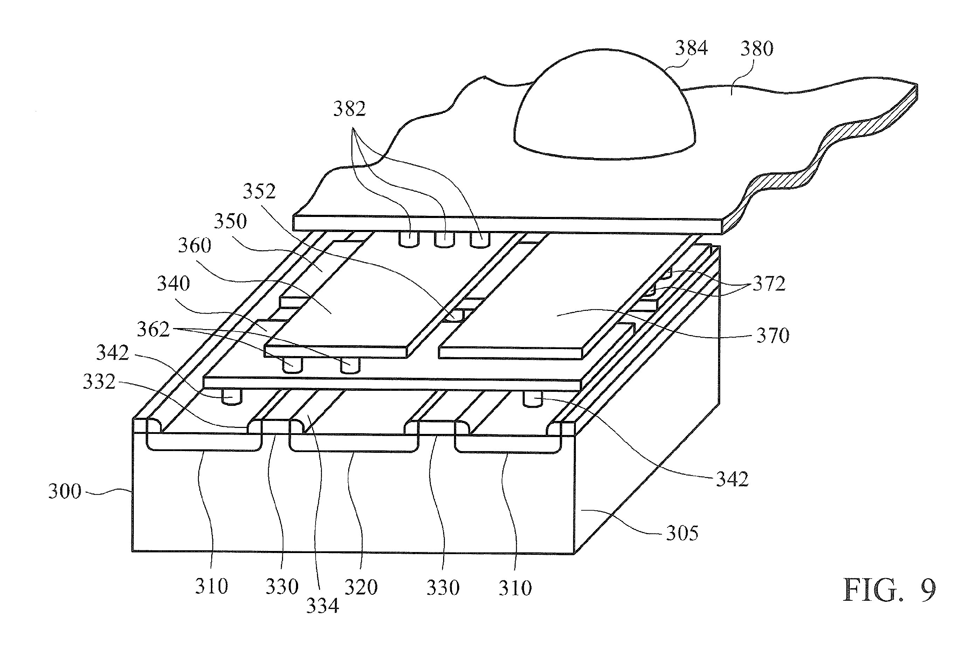

FIG. 9 shows a portion of a semiconductor chip 300 having two sources 310 and a drain 320. In the illustrative example, device 300 is shown with a P substrate 305. In another embodiment, P substrate 305 is deposited on top of a P-substrate (not shown). Sources 310 and drain 320 are preferably n-type dopant implants into P substrate 305.

As shown in FIG. 9, gate 330 is comprised of a polysilicon gate over a SiO₂ or Si₃N₄ insulating layer (not shown) and is placed between source 310 and drain 320. Adjacent to gate 330 are spacers 332 and 334, preferably comprised of SiO₂ or Si₃N₄, and partially extending over the source 310 and drain 320, respectively. Source runners 340 and drain runners 350 are formed on a first interconnect layer and is preferably comprised of metal, although other conductive materials may be used. In particular, multiple sources 310 are interconnected by source runner 340 using vias 342. Preferably source runner 340 is in a substantially orthogonal orientation to source 310 and drain 320.

FIG. 9 also shows source runners 360 and drain runners 370 formed on a second interconnect layer and is preferably comprised of metal, although other conductive materials may be used. Source runner 360 interconnects source runners 340 using vias 362. Preferably source runners 360 are in a substantially parallel orientation with respect to the source 310.

Drain runners 350 are interconnected by drain runners 370 using vias 372. Preferably, drain runner 370 is in a substantially parallel orientation with respect to the drain 320.

Like the first interconnect layer, only one source and drain runners 360 and 370, respectively, are shown, but in the preferred embodiment multiple source and drain runners 360 and 370 would be used and are, preferably, interleaved with each other.

FIG. 9 shows source pad 380 formed on a third interconnect layer, which is preferably comprised of metal, although other conductive materials may be used. Source pad 380 is connected to source runners 360 using vias 382. Also shown is solder bump 384 formed on source pad 380. These solder bumps provide connections between the sources 310, drains 320, and gates 330 with external circuits.

In the preferred embodiment the, vias (for instance vias 342, 352, 362, 372 and 382) form conductive interconnects and are comprised preferably of tungsten, although other conductive materials may be used.

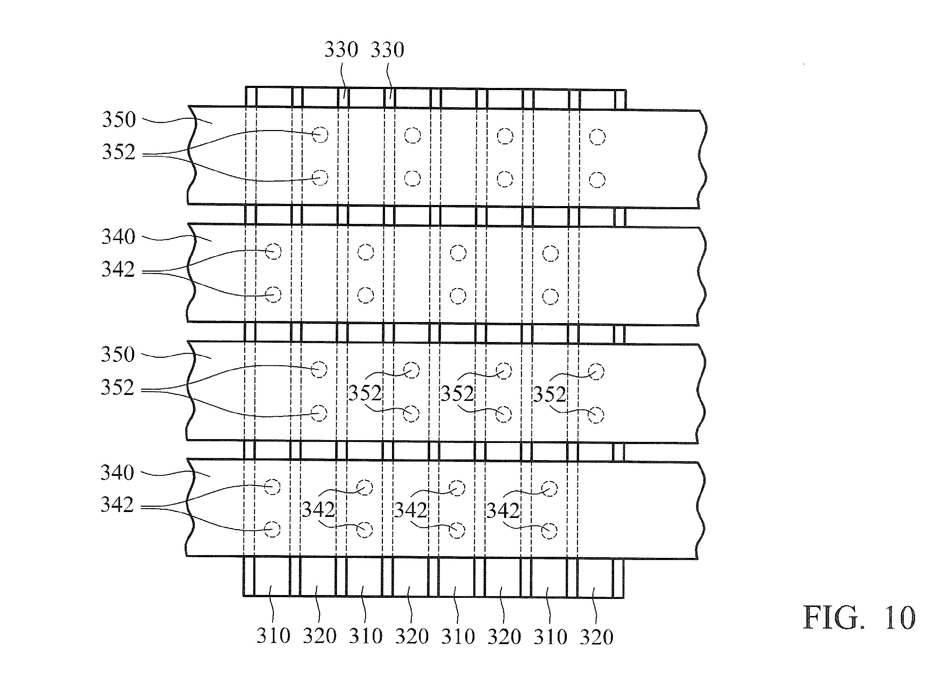

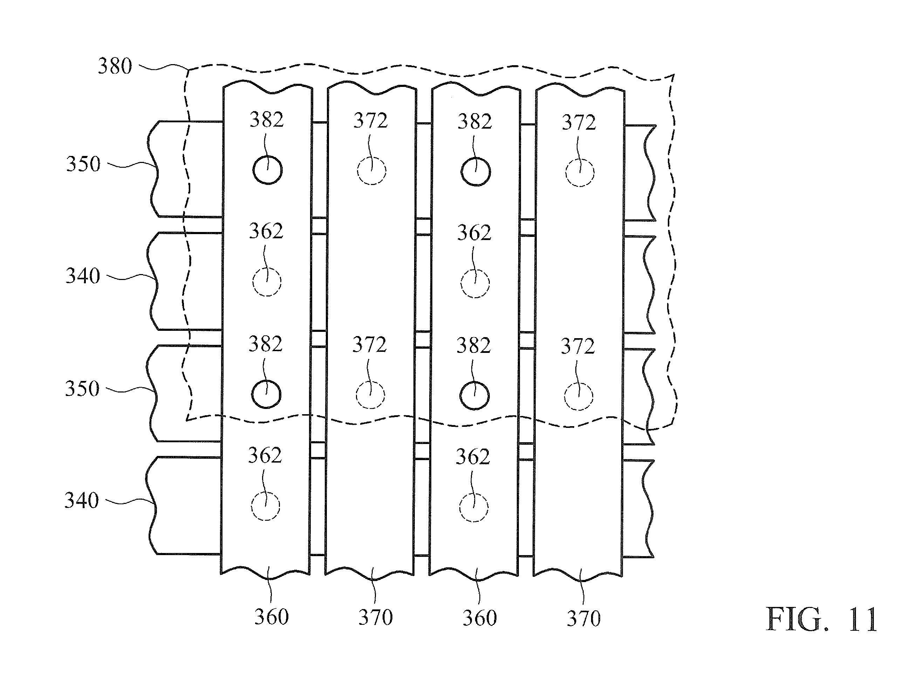

FIG. 10 is a top plan view of the embodiment shown in FIG. 9, which shows additional sources 310, drains 320 and first-layer interconnect source runners 340 and drain runners 350. Sources 310 and drains 320 are shown having a substantially vertical orientation while source runners 340 and drain runners 350 are shown in a substantially horizontal orientation. Also shown are vias 342 and 352 interconnecting the source runners 340 and drain runners 350 to sources 310 and drains 320, respectively. It should be noted that, although FIG. 10, for instance, shows at a point of connection the use of two vias, one via could be used, as shown in FIG. 11, or more than two, as shown in FIG. 9 for vias 182.

FIG. 11 is a top plan view of the embodiment of FIG. 9, which shows the first interconnect layer (forming source runners 340 and drain runners 350), second interconnect layer (forming source runners 360 and drain runners 370) and third interconnect layer forming source pad 380 (in outline form).

Source runners 340 and drain runners 350 are laid out in a substantially horizontal orientation. Source runners 360 overlay source runners 340 and are interconnected using vias 362. Drain runners 370 overlay drain runners 350 and are interconnected using vias 372. Source pad 380 is shown in FIG. 11 overlaying source runners 360 and drain runners 370, but is only connected to source runners 360 by vias 382.

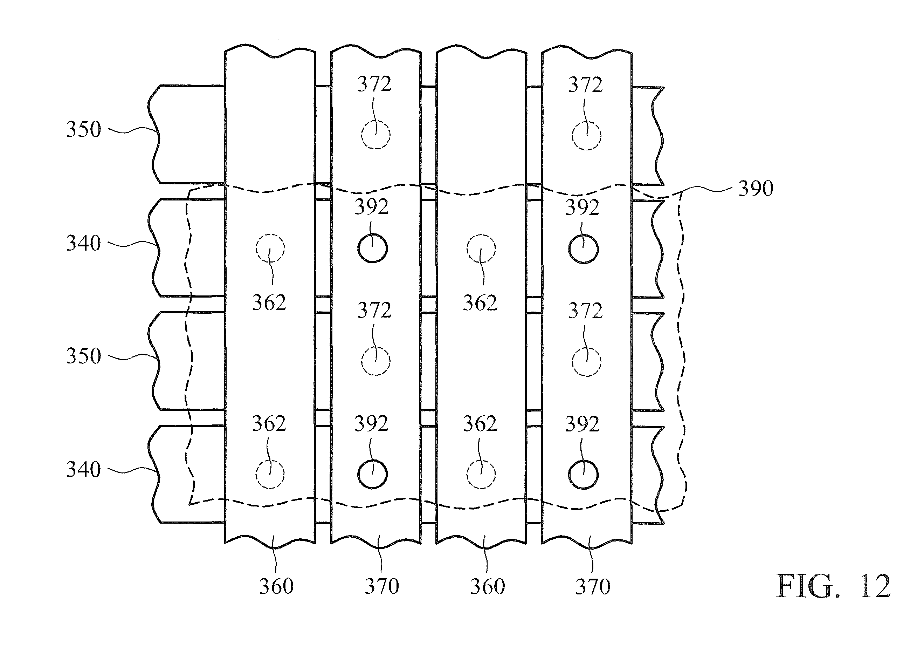

FIG. 12 is a top plan view of the embodiment of FIG. 9, which shows the first interconnect layer (forming source runners 340 and drain runners 350), second interconnect layer (forming source runners 360 and drain runners 370) and a third interconnect layer forming a drain pad 390 (in outline form).

Source runners 340 and drain runners 350 are laid out in a substantially horizontal orientation. Source runners 360 overlay source runners 340 and interconnect source runners 340 using vias 362. Drain runners 370 overlay drain runners 350 and interconnect drain runners 370 using vias 372. Drain pad 390 is shown overlaying source runners 360 and drain runners 370, but is only connected to drain runners 370 by vias 392.

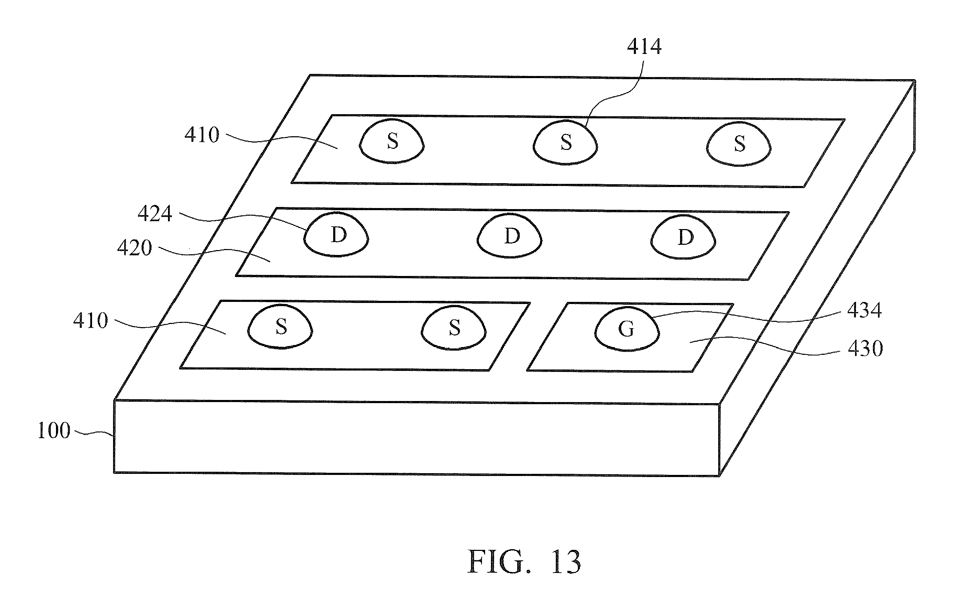

FIG. 13 shows a layout where each source pad 410 and drain pad 420 are shaped as "stripes" and are interleaved with each other. In the preferred embodiment gate pad 430 would be placed with a shortened source pad 410or shortened drain pad 420 as needed.

Utilizing the electronic package of the embodiments of the invention, the chip pad sufficiently contacts the substrate pad. Heat from the semiconductor chip is conducted to the substrate via the chip pad, the substrate pad, and the thermal via hole along the dissipation path, and the dissipation path is the straight line. The dissipation path is simplified, and the heat dissipation efficiency of the electronic package is improved.

Use of ordinal terms such as "first", "second", "third", etc., in the claims to modify a claim element does not by itself connote any priority, precedence, or order of one claim element over another or the temporal order in which acts of a method are performed, but are used merely as labels to distinguish one claim element having a certain name from another element having the same name (but for use of the ordinal term).

While the invention has been described by way of example and in terms of the preferred embodiments, it is to be understood that the invention is not limited to the disclosed embodiments. On the contrary, it is intended to cover various modifications and similar arrangements (as would be apparent to those skilled in the art). Therefore, the scope of the appended claims should be accorded the broadest interpretation so as to encompass all such modifications and similar arrangements.

## Claims

1. An electronic package, comprising:
a substrate having a plurality of substrate pads; and
a semiconductor chip mounted on the substrate, wherein the semiconductor chip comprises a plurality of chip pads electrically connected to the substrate pads of the substrate respectively.

2. The electronic package of claim 1, wherein the substrate pads and the chip pads are both trapezoidal.

3. The electronic package of claim 1, wherein the semiconductor chip comprises a plurality of active elements electrically connected to the chip pads.

4. The electronic package of claim 3, wherein the active elements comprise a plurality of power transistors.

5. The electronic package of claim 1, wherein the substrate comprises a plurality of thermal via holes connected to the substrate pads.

6. The electronic package of claim 5, wherein more than one of the thermal via holes is connected to each of the substrate pads.

7. The electronic package of claim 5, wherein each of the substrate pads comprises a wider side and a narrower side opposite the wider side.

8. The electronic package of claim 7, wherein at least one of the substrate pads has a wider side adjacent to the narrower side of another substrate pad.

9. The electronic package of claim 7, wherein the thermal via holes are adjoined with the substrate pad in a location that is adjacent to the wider side.

10. The electronic package of claim 5, wherein heat from the semiconductor chip is conducted to the substrate via the chip pad, the substrate pad, and the thermal via hole along a dissipation path, and the main dissipation path is a straight line.

11. The electronic package of claim 10, wherein the substrate comprises a plurality of traces, and the traces are perpendicular to the thermal via holes.

12. The electronic package of claim 1, wherein the semiconductor chip comprises a bottom surface, and the chip pads protrude from the bottom surface, and the bottom surface comprises insulation material.

13. The electronic package of claim 1, wherein the shape of the substrate pad is the same as the shape of the corresponding chip pad, and the dimensions of the substrate pad are similar to the dimensions of the corresponding chip pad.

14. The electronic package of claim 1, wherein the substrate comprises a printed circuit board or an interposer.

15. The electronic package of claim 1, wherein the heat from the pads of the semiconductor chip on a top side and a bottom side thereof are transmitted to the substrate pads to be dissipated by a plurality of thermal via holes.
